**Europäisches Patentamt**

**European Patent Office**

**Office européen des brevets**

(11) Numéro de publication: **0 274 958 B1**

# FASCICULE DE BREVET EUROPEEN

(45) Date de publication de fascicule du brevet: **22.07.92** (51) Int. Cl.5: **H04B 7/01**

(21) Numéro de dépôt: **87402956.4**

(22) Date de dépôt: **22.12.87**

(54) **Dispositif de compensation dans un récepteur radiofréquence de l'effet Doppler produit par le mouvement relatif d'un récepteur par rapport à un émetteur accordé sur la même fréquence.**

(30) Priorité: **30.12.86 FR 8618356**

(43) Date de publication de la demande:
**20.07.88 Bulletin 88/29**

(45) Mention de la délivrance du brevet:
**22.07.92 Bulletin 92/30**

(84) Etats contractants désignés:
**DE GB IT**

(56) Documents cités:
**FR-A- 1 319 646**
**FR-A- 1 330 064**
**FR-A- 1 443 866**
**FR-A- 2 159 187**
**US-A- 3 435 344**

(73) Titulaire: **THOMSON-CSF**
**51, Esplanade du Général de Gaulle**
**F-92800 Puteaux(FR)**

(72) Inventeur: **Bruas, Patrick**
**THOMSON-CSF SCPI 19, avenue de Messine**
**F-75008 Paris(FR)**
Inventeur: **Prigent, Jean-Paul**
**THOMSON-CSF SCPI 19, avenue de Messine**
**F-75008 Paris(FR)**

(74) Mandataire: **Lincot, Georges et al**
**THOMSON-CSF SCPI**
**F-92045 PARIS LA DEFENSE CEDEX 67(FR)**

## Description

La présente invention concerne un dispositif de compensation dans un récepteur radiofréquence de l'effet Doppler produit par le mouvement relatif d'un récepteur par rapport à un émetteur accordé sur la même fréquence.

Elle s'adresse plus particulièrement à la réalisation de récepteurs de communication par satellite embarqué sur des véhicules terrestres ou des aéronefs.

Ce type de récepteur comporte classiquement une "chaîne de transposition, un filtre passe-bande de prédétection en fréquence intermédiaire, une boucle à verrouillage de phase composée d'un filtre de boucle et d'un oscillateur accordable en tension. Dans certaines réalisations il est tenu compte de l'effet Doppler produit par les déplacements relatifs du satellite et du récepteur en élargissant la bande passante des filtres de prédétection. Cette dernière est calibrée pour tenir compte à la fois de la bande de réception du signal et du décalage en fréquence produit par l'effet Doppler. Cependant en élargissant la bande passante des filtres de prédétection la puissance de bruit à la sortie des filtres est augmentée et le rapport signal à bruit est diminué.

Pour éviter cet inconvénient, une deuxième solution mise en oeuvre dans d'autres réalisations comme celle décrite par exemple dans le brevet FR 1.319.646 consiste à réaliser une compensation globale en amont de la chaîne de démodulation, cette compensation étant limitée à la bande passante du récepteur de mesure. Cependant, si la bande passante du récepteur de mesure est large la compensation obtenue est affectée par le bruit et ne permet pas un asservissement correct de la boucle à verrouillage de phase. A contrario, si la bande passante est étroite, l'asservissement de la boucle à verrouillage de phase peut être plus précis à condition que les décalages soient lents pour tenir compte des inerties liées à l'étroitesse de la bande passante. Toutefois cet asservissement ne peut être réalisé que dans la bande limitée du récepteur et pour éviter de travailler en dehors de celle-ci les décalages autoritaires de fréquence doivent être exécutés chaque fois qu'il est nécessaire pour garder à l'asservissement une énergie suffisante, ce qui provoque toujours dans ce type de réalisation une coupure momentanée de la liaison.

Le but de l'invention est de pallier les inconvénients précités.

A cet effet, l'invention a pour objet, un dispositif de compensation, dans un récepteur radiofréquence, de l'effet Doppler produit par le mouvement relatif du récepteur par rapport à un émetteur accordés sur une même première fréquence, le récepteur comprenant une chaîne de démodulation constituée par un premier filtre passe bande de prédétection en fréquence intermédiaire, des moyens de transposition formés par un mélangeur de fréquence et un oscillateur local à fréquence ajustable pour transposer les signaux radio électriques dans la bande de fréquence du filtre passe bande à fréquence intermédiaire et une boucle à verrouillage de porteuse couplée à la sortie du filtre passe bande à fréquence intermédiaire et constituée par un oscillateur à fréquence adjustable, un comparateur de phase et un deuxième filtre de boucle pour commander la fréquence de l'oscillateur en fonction de l'écart de phase fourni par le discriminateur, caractérisé en ce qu'il comprend un dispositif de détection de la fréquence Doppler accordé sur une deuxième fréquence de l'émetteur et fournissant un écart de fréquence $\Delta F_1$ fonction du mouvement relatif du récepteur par rapport à l'émetteur, un dispositif de conversion pour calculer à partir de l'écart de fréquence $\Delta F_1$ un écart de fréquence $\Delta F_2$ proportionnel à l'écart $\Delta F_1$ dans le rapport des première et deuxième fréquence, des moyens pour ajouter l'écart de fréquence $\Delta F_2$ calculé à la fréquence d'accord de chacun des oscillateurs, ainsi qu'un troisième filtre identique au premier filtre et couplé entre l'oscillateur à la fréquence ajustable et le comparateur pour compenser le retard introduit par le premier filtre.

D'autres caractéristiques et avantages de l'invention apparaîtront ci-après à l'aide de la description qui va suivre faite en regard des dessins annexés qui représentent :

La figure 1, le principe de communication entre un satellite et un récepteur embarqué sur un engin terrestre ou un aéronef selon l'invention.

Les figures 2 et 3 un mode de filtrage adapté à la récupération de la fréquence Doppler et des informations transmises par le satellite.

La figure 4 un mode de réalisation d'un dispositif de compensation selon l'invention couplé à une chaîne de réception.

La figure 5 une variante de réalisation d'une chaîne de réception d'un récepteur selon l'invention.

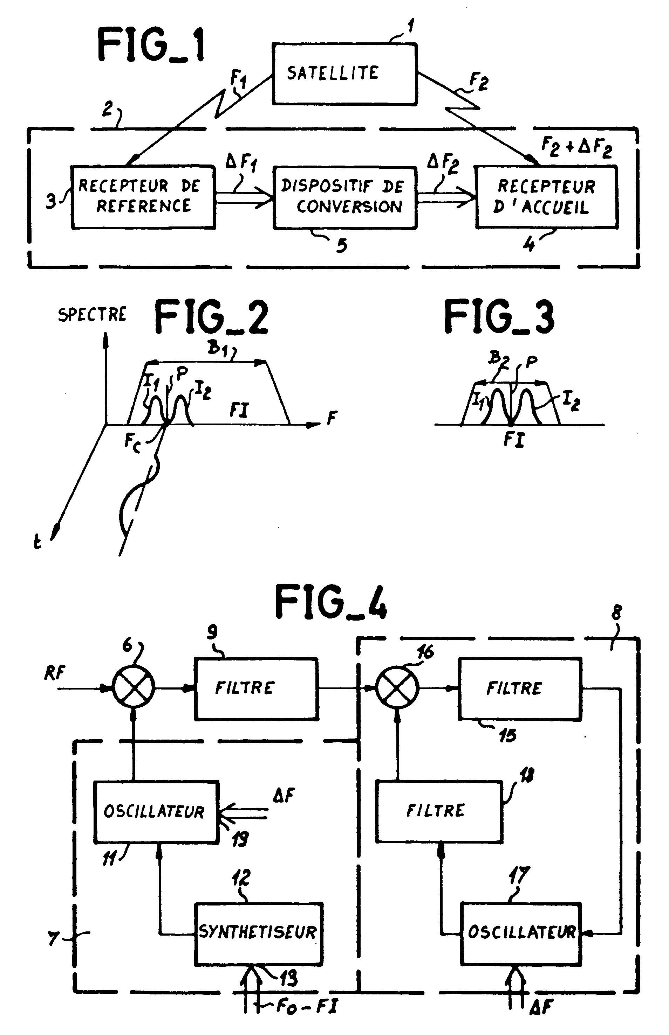

Le dispositif de communication qui est représenté à la figure 1 comprend un satellite 1 qui transmet des informations à destination d'un récepteur 2 fixé sur un véhicule terrestre ou un aéronef non représentés.

La récepteur 2 qui est représenté à l'intérieur d une ligne en pointillé comprend un récepteur de référence 3 couplé à un récepteur d'accueil 4 au travers d'un dispositif de conversion de fréquence 5. Le satellite 1 transmet par son émetteur un premier signal de fréquence F1 à destination du récepteur de référence 3 et des signaux d'information sur une fréquence porteuse F2 à destination du récepteur d'accueil 4 lorsque le récepteur 2 et le satellite 1 sont en déplacement relatif l'un par rapport à l'autre. Le récepteur de référence 3 reçoit une fréquence F1 + ΔF1 et le récepteur d'accueil reçoit une fréquence porteuse égale à F2 + ΔF2, ΔF1 et ΔF2 correspondant à la vitesse de défilement relative du satellite 1 par rapport au dispositif de réception 2. La variation de fréquence ΔF1 est détectée par le récepteur de référence 3 et est transmise au dispositif de conversion 5 qui la transforme en une fréquence $\Delta F2 = \frac{F2}{F1} \times \Delta F1$ et le résultat obtenu ΔF2 est appliqué au récepteur d'accueil 4 ce qui permet, après soustraction de la fréquence reçue F2 + ΔF2, de restituer la fréquence porteuse F2 telle qu'elle est émise par le satellite 1.

La détection du décalage de fréquence ΔF1 a lieu suivant le diagramme de la figure 2 et la compensation par le décalage ΔF2 a lieu de la façon représentée à la figure 3. Sur le diagramme de la figure 2 la bande passante du filtre de prédétection du récepteur de référence 3 est élargie pour permettre la récupération de l'information transportée par le signal radioélectrique émis à la fréquence F1 par le satellite 1. L'onde porteuse de fréquence FC et les bandes latérales $I_1$, $I_2$ de la modulation reçue sont continuellement déplacées par rapport à la fréquence centrale FI du filtre de prédétection. L'écart de fréquence mesuré entre les deux fréquences FC et FI déterminent l'écart de fréquence ΔF1 dû à l'effet Doppler. Sur le diagramme de la figure 2, l'action du décalage de fréquence ΔF2 sur le récepteur d'accueil 4 permet de recentrer l'ensemble constitué par la fréquence de l'onde porteuse FC et les deux bandes latérales $I_1$ et $I_2$ qui transportent la modulation sur la fréquence centrale F1 du filtre de fréquence intermédiaire du récepteur d'accueil . On réduit ainsi la bande passante du filtre à ce qui est strictement nécessaire pour récupérer les informations.

Dans l'exemple qui vient d'être décrit, la fréquence F1 de référence issue du satellite est supposée être diffusée en permanence. Cette solution convient plus particulièrement au cas où le satellite est géosynchrone et à faible inclinaison. Dans ce cas, l'effet Doppler obtenu est dû au mouvement radial de la source d'émission des ondes électromagnétiques. Ce mouvement est relativement lent et n'excède pas 5 m.s $^{-1}$.

Cependant pour les satellites à défilement pour lesquels l'effet Doppler est plus important on peut préférer, plutôt que de faire émettre le satellite sur une fréquence fixe, faire une estimation à l'aide d'un calculateur du décalage de fréquence dû à l'effet Doppler. Cette estimé peut, par exemple, être obtenue à tout instant à partir des informations de vitesse et de position du satellite fournie par le système de télémesure des engins sur lesquels le récepteur est embarqué et des éphémérides connues du satellite. Cette solution peut également convenir au cas où le véhicule porteur du récepteur est équipé d'une centrale inertielle, cette dernière pouvant fournir au calculateur les informations de vitesse et d'accélération du véhicule.

Naturellement, suivant les types de réalisation envisagés une combinaison des deux méthodes précédentes reste encore possible.

Lorsque la mesure du décalage de fréquence ΔF2 est obtenue suivant l'une quelconque des méthodes précédentes, l'information Doppler est délivrée de la façon décrite précédemment, pour centrer le spectre de bande du signal reçu au milieu de la bande passante du filtre du récepteur d'accueil.

Un mode de réalisation analogique d'un récepteur d'accueil est représenté à la figure 4. Il comprend un dispositif de transposition de fréquence formé par un mélangeur de fréquence 6 et oscillateur local 7 représenté à l'intérieur d'une ligne en pointillés ; une boucle à verrouillage de porteuse 8 également représentée à l'intérieur d'une ligne en pointillés et un filtre 9 à fréquence intermédiaire FI pour coupler la sortie du dispositif de transposition de fréquence F6 à une entrée 10 de la boucle à verrouillage de porteuse 8. L'oscillateur local 7 comprend de façon connue un oscillateur commandable numériquement ou en tension 11 et un synthétiseur 12 pour ajuster la fréquence de l'oscillateur 11 a une valeur de consigne.

La valeur de consigne est appliquée sur une première entrée 13 du synthétiseur 12.

La boucle à verrouillage de porteuse 8 comprend également de façon connue un filtre de boucle 15 couplé entre la sortie d'un comparateur de phase 16 et un oscillateur commandable numériquement ou en tension 17. La fréquence de sortie de l'oscillateur 17 est appliquée sur une première entrée du comparateur 16 au travers d'un filtre 18 dont les caractéristiques de filtrage sont identiques à celles du filtre à fréquence intermédiaire 9. Le comparateur 16 possède une deuxième entrée qui est reliée à la sortie du filtre à fréquence intermédiaire 9. Le décalage en fréquence ΔF est appliqué sous la forme d'une tension sur des entrées de commande en tensions, notées respectivement 19 et 20 sur les entrées de commande des oscillateurs 11 et 17.

En désignant par :

F0 la fréquence du canal de transmission reliant le satellite au récepteur d'accueil,

FI la fréquence intermédiaire sur lequel est calé le filtre 9,

et par FP la fréquence de l'onde porteuse du signal radiofréquence reçue, on obtient à la sortie du transposeur de fréquence 6 deux signaux de fréquence F1 et F2 tels que :

$$F1 = FP - (F0 - FI + \Delta F) \quad (1)$$
$$\text{et } F2 = FP + (F0 - FI + \Delta F) \quad (2)$$

seule la fréquence F1 est restituée à la sortie du filtre 9 et si $\Delta F$ mesuré est égal strictement à la différence FC - F0 la fréquence porteuse transposée du signal reçu est rigoureusement égale à la fréquence centrale FI du filtre à fréquence intermédiaire 9. Comme la fréquence de la boucle à verrouillage de porteuse 8 s'asservit sur la fréquence F1 on obtient comme fréquence pour l'oscillateur 17 $F = F_1 - \Delta F$.

Par contre si $\Delta F$ est légèrement différente de FP - F0, la fréquence F1 obtenue est distante de $\pm \epsilon$ de la fréquence centrale FI du filtre 9. Dans ces conditions la fréquence de l'oscillateur 17 est égale à $FI - \Delta F \pm \epsilon$.

Pour rendre minimal le régime transitoire des deux boucles 7 et 8 lorsque l'écart de fréquence $\Delta F$ varie, les deux oscillateurs de fréquence 17 et 19 sont construits de façon à avoir indépendamment l'un de l'autre le même comportement transitoire et dans ce cas les deux filtres 9 et 18 ont les mêmes caractéristiques de bande passante et de temps de propagation de groupe.

L'avantage de cette solution est qu'elle permet un fonctionnement autonome des récepteurs lorsque la phase d'acquisition du canal a été préalablement réalisée, c'est-à-dire lorsque le dispositif de la figure 4 est en phase de poursuite Doppler. Dans ce cas les commandes du synthétiseur 7 peuvent être bloquées et l'asservissement suit la fréquence reçue au moyen de la boucle à verrouillage de porteuse 8. Dans ce mode de fonctionnement une vérification de la position de la porteuse à l'intérieur de la bande passante du filtre de prédétection en fréquence intermédiaire 9 peut être contrôlée à tout instant. Dès que l'effet Doppler tend à trop éloigner la fréquence porteuse du centre de la bande du filtre de fréquence intermédiaire 9, un dispositif externe, non représenté, pourra effectuer un décalage autoritaire.Ce dispositif sera éventuellement constitué par un processeur de signal qui pourra introduire le décalage de fréquence Doppler $\Delta F$ mesuré sur les deux oscillateurs 17 et 19 pour replacer la fréquence porteuse du signal à une valeur voisine du centre de la bande passante du filtre de fréquence intermédiaire 9 et permettre une démodulation des signaux reçus dans de bonnes conditions après un régime transitoire de durée très réduite.

Un autre avantage obtenu par cette solution est que les perturbations sur les informations sont limitées du fait que les durées des régimes transitoires sont réduites. Cela permet de réduire la redondance des informations transmises ou la capacité de correction d'erreur des dispositifs de réception qu'il faut mettre pour assurer une transmission correcte des informations.

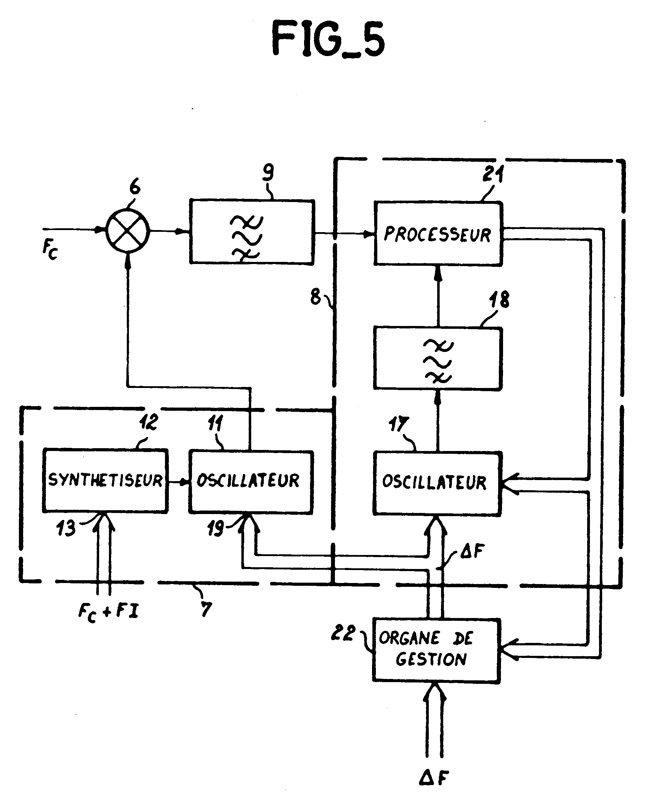

Une réalisation correspondant à ce dernier mode de fonctionnement est représentée à la figure 5. Sur cette figure les éléments homologues à ceux de la figure 4 sont représentés avec les mêmes références. En contraste avec le dispositif de compensation qui est représenté à la figure 4, le dispositif de la figure 5 comprend à la place du filtre de boucle 15 et du comparateur 16 un processeur de signal 21 qui traite les signaux fournis respectivement par les filtres de fréquence intermédiaire 9 et 18 pour générer les signaux de commande à l'oscillateur 17 ainsi qu'un organe de gestion 22. Les décalages en fréquence produits à l'intérieur des filtres de fréquence intermédiaire 9 et 18 sont mesurés par le processeur 21 qui transmet corrélativement des signaux de commande à un organe de gestion 22 pour appliquer, chaque fois que cela est nécessaire, les écarts de fréquence $\Delta F$ pour recaler le synthétiseur 7 et la boucle à verrouillage de porteuse 8.

Bien évidemment, la portée de l'invention n'est pas limitée à l'exemple de réalisation qui vient d'être décrit, qui concerne plus principalement des communications satellites. On concevra que ce procédé peut également être utilisé pour améliorer d'autres types de transmission notamment des transmissions numériques entre aéronefs rapides, par exemple, pour lesquels dans les gammmes de fréquence HF, VHF ou UHF la dérive en fréquence peut être notable par rapport à la fréquence émise.

**Revendications**

1. Dispositif de compensation, dans un récepteur radiofréquence, de l'effet Doppler produit par le mouvement relatif du récepteur (2, 4) par rapport à un émetteur (1) accordés sur une même première fréquence ($F_2$), le récepteur comprenant une chaîne de démodulation constituée par un premier filtre (9) passe bande de prédétection en fréquence intermédiaire, des moyens de transposition formés par un mélangeur de fréquence (6) et un oscillateur local (7) à fréquence ajustable pour transposer les signaux radio électriques dans la bande de fréquence du filtre passe bande à fréquence intermédiaire et une boucle à verrouillage de porteuse (8) couplée à la sortie du filtre passe bande à fréquence intermédiaire et constituée par un oscillateur à fréquence adjustable (17), un comparateur de phase (16) et un deuxième filtre de boucle (15) pour commander la fréquence de l'oscillateur (17) en fonction de l'écart de phase fourni par le discriminateur (16), caractérisé en ce qu'il comprend un dispositif de détection (3) de la fréquence Doppler accordé sur une deuxième fréquence ($F_1$) de

l'émetteur (1) et fournissant un écart de fréquence $\Delta F_1$ fonction du mouvement relatif du récepteur (2) par rapport à l'émetteur, un dispositif de conversion (5) pour calculer à partir de l'écart de fréquence $\Delta F_1$ un écart de fréquence $\Delta F_2$ proportionnel à l'écart $\Delta F_1$ dans le rapport des première ($F_2$) et deuxième fréquence ($F_1$), des moyens (12, 17) pour ajouter l'écart de fréquence $\Delta F_2$ calculé à la fréquence d'accord de chacun des oscillateurs (11, 12) ainsi qu'un troisième filtre (18) identique au premier filtre (9) et couplé entre l'oscillateur à la fréquence ajustable (17) et le comparateur (16) pour compenser le retard introduit par le premier filtre (9).

2. Dispositif selon la revendication caractérisé en ce que les temps de réponse des deux oscillateurs (11, 17) sont les mêmes.

3. Dispositif selon l'une quelconque des revendications 1 et 2, caractérisé en ce que le filtre de boucle (15) et le comparateur de phase (16) sont réalisés à l'aide d'un processeur de signal (21).

4. Dispositif selon l'une quelconque de revendications précédentes, caractérisé en ce que l'écart de fréquence Doppler est appliquée simultanément aux deux oscillateurs (11, 17) chaque fois que cela est nécessaire pour recaler la fréquence démodulée au milieu de la bande passante du filtre de fréquence intermédiaire (9).

5. Dispositif selon l'une quelconque des revendications 1 à 4 caractérisé en ce que les deux oscillateurs (11, 17) sont commandés en tension.

6. Dispositif selon l'une quelconque de revendications 1 à 5 caractérisé en ce que les deux oscillateurs (11, 17) sont commandés numériquement.

## Claims

1. A compensating device, in a radio frequency receiver, for the Doppler effect produced by the relative movement of the receiver (2, 4) in relation to a transmitter (1), both being tuned to a first frequency ($F_2$), the receiver comprising a demodulating circuit constituted by a first pass band filter (9) for IF predetection, transposition means constituted by a frequency mixer (6) and a local oscillator (7) with an adjustable frequency in order to transpose the electrical radio signals to the frequency band of the IF pass band filter and a carrier locked loop (8) coupled with the output of the IF pass band filter and constituted by an adjustable frequency oscillator (17), a phase comparator (16) and a second loop filter (15) in order to control the frequency of the oscillator (17) as a function of the phase offset furnished by the discriminator (16), characterized in that it comprises a detection device (3) for the Doppler frequency tuned to a second frequency ($F_1$) of the transmitter (1) and furnishing a frequency offset $\Delta F_1$ as a function of the relative movement of the receiver (3) in relation to the transmitter, a conversion device (5) in order to calculate from the frequency offset $\Delta F_1$ a frequency offset $\Delta F_2$ proportional to the offset $\Delta F_1$ in the ratio of the first ($F_2$) and the second frequency ($F_1$), means (12, 17) for the addition of the frequency offset $\Delta F_2$ calculated to the tuned frequency of each of the oscillators (11, 12) as well as a third filter (18) identical to the first filter (9) and coupled between the adjustable frequency oscillator (17) and the comparator (16) in order to compensate for the delay introduced by the first filter (9).

2. The device as claimed in claim 1, characterized in that the response times of the two oscillators (11, 17) are the same.

3. The device as claimed in claim 1 or in claim 2, characterized in that the loop filter (15) and the phase comparator (16) are realized by means of a signal processor (21).

4. The device as claimed in any one of the preceding claims, characterized in that the Doppler offset frequency is applied simultaneously to the two oscillators (11, 17) each time that this is necessary in order to reset the demodulated frequency at the center of the pass band of the IF filter (9).

5. The device as claimed in any one of the preceding claims 1 through 4, characterized in that the two oscillators (11, 17) are voltage controlled.

6. The device as claimed in any one of the preceding claims 1 through 5, characterized in that the two oscillators (11, 17) are digitally controlled.

## Patentansprüche

1. Einrichtung für die Kompensation des Doppler-Effektes in einem Hochfrequenzempfänger, wobei der Doppler-Effekt durch die relative Bewegung des Empfängers (2, 4) in bezug auf einen Sender (1), die beide auf eine gleiche erste Frequenz ($F_2$) abgestimmt sind, erzeugt wird, wobei der Empfänger einen Demodulationszweig umfaßt, der versehen ist mit einem ersten Bandpaßfilter (9) für die Vorerfassung auf einer Zwischenfrequenz, Umsetzermitteln, die durch einen Frequenzmischer (6) und einen Überlagerungsoszilator (7) mit einstellbarer Frequenz gebildet werden, um die Hochfrequenzsignale in das Frequenzband des Zwischenfrequenz-Bandpaßfilters umzusetzen, und mit einer Trägerfrequenz- Verriegelungsschleife (8), die mit dem Ausgang des Zwischenfrequenz-Bandpaßfilters gekoppelt ist und einen Oszillator (17) mit einstellbarer Frequenz, einen Phasenkomparator (16) und ein zweites Schleifenfilter (15) umfaßt, um die Frequenz des Oszillators (17) in Abhängigkeit von der vom Diskriminator (16) gelieferten Phasenabweichung zu steuern, dadurch gekennzeichnet, daß sie versehen ist mit einer auf eine zweite Frequenz ($F_1$) des Senders (1) abgestimmten Dopplerfrequenz-Detektoreinrichtung (3), die eine von der relativen Bewegung des Empfängers (2) in bezug auf den Sender abhängende Frequenzabweichung $\Delta F_1$ liefert, einer Umformungseinrichtung (5), die aus der Frequenzabweichung $\Delta F_1$ eine Frequenzabweichung $\Delta F_2$ berechnet, die zur Abweichung $\Delta F_1$ im Verhältnis der ersten ($F_2$) und der zweiten Frequenz ($F_1$) proportional ist, Mitteln (12, 17) zum Hinzufügen der berechneten Frequenzabweichung $\Delta F_2$ zur Abstimmfrequenz eines jeden der Oszillatoren (11, 12) sowie mit einem dritten Filter (18), das dem ersten Filter (9) gleich ist und zwischen den Oszillator (17) mit einstellbarer Frequenz und den Komparator (16) geschaltet ist, um die vom ersten Filter (9) bewirkte Verzögerung zu kompensieren.

2. Einrichtung gemäß Anspruch 1, dadurch gekennzeichnet, daß die Ansprechzeiten der zwei Oszillatoren (11, 17) gleich sind.

3. Einrichtung gemäß einem der Ansprüche 1 und 2, dadurch gekennzeichnet, daß das Schleifenfilter (15) und der Phasenkomparator (16) mit Hilfe eines Signalprozessors (21) verwirklicht sind.

4. Einrichtung gemäß einem der vorangehenden Ansprüche, dadurch gekennzeichnet, daß die Dopplerfrequenzabweichung gleichzeitig jedesmal dann an die beiden Oszillatoren (11, 17) angelegt wird, wenn dies notwendig ist, um die demodulierte Frequenz wieder auf die Mitte des Durchlaßbandes des Zwischenfrequenz-Filters (9) einzustellen.

5. Einrichtung gemäß einem der Ansprüche 1 bis 4, dadurch gekennzeichnet, daß die zwei Oszillatoren (11, 17) spannungsgesteuert sind.

6. Einrichtung gemäß einem der Ansprüche 1 bis 5, dadurch gekennzeichnet, daß die zwei Oszillatoren (11, 17) digital gesteuert sind.

# FIG_1

SATELLITE  1

$F_1$  2  $F_2$

$F_2 + \Delta F_2$

3

| RECEPTEUR DE REFERENCE | $\Delta F_1$ | DISPOSITIF DE CONVERSION | $\Delta F_2$ | RECEPTEUR D'ACCUEIL |

5  4

# FIG_2

SPECTRE

$B_1$

$I_1$  P  $I_2$

FI

$F_c$

F

t

# FIG_3

$B_2$  P

$I_1$  $I_2$

FI

# FIG_4

8

RF

6  9

FILTRE

16

FILTRE

15

OSCILLATEUR  $\Delta F$  19

11

FILTRE  18

SYNTHETISEUR  12

OSCILLATEUR  17

7

13

$-F_0 - FI$

$\Delta F$

7

# FIG_5